(19) Europäisches Patentamt
European Patent Office
Office européen des brevets

(11) **EP 4 708 655 A2**

(12) **EUROPEAN PATENT APPLICATION**

(43) Date of publication:
**11.03.2026 Bulletin 2026/11**

(21) Application number: **25201140.8**

(22) Date of filing: **09.09.2025**

(51) International Patent Classification (IPC):
**H02M 1/32** (2007.01)   **H02M 3/158** (2006.01)

(52) Cooperative Patent Classification (CPC):
**H02M 1/32; H02M 3/158;** G01R 31/52

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority:   **09.09.2024   US 202418828579**

(71) Applicant: **Bel Fuse (Macao Commercial Offshore) Limited**
**Macau (MO)**

(72) Inventors:
• LU, Hongliang
 Hangzhou, 310053 (CN)
• ZHENG, Yanli
 Hangzhou, 310053 (CN)
• REN, Dawei
 Hangzhou, 310053 (CN)

(74) Representative: **Page White Farrer**
 **Bedford House**
 **21a John Street**
 **London WC1N 2BF (GB)**

(54) **NON-ISOLATED DC-DC CONVERTER WITH POWER-SWITCH SHORT CIRCUIT DETECTION**

(57)    A non-isolated DC-DC converter detects short circuits of its switching devices to avoid faulty and unsafe operating conditions. The converter includes a transformer and switching circuitry that includes upper switches and middle switches of a primary-side inverter and lower switches of a secondary-side rectifier. Short-circuit detection circuitry has (1) a resistive divider to establish normal values of a primary-side test node and a secondary-side test node in a non-short-circuit condition during pre-operation with all the switches in an OFF condition, and (2) sensing circuitry operative during the pre-operation of the converter to detect abnormal values of the primary-side and secondary-side test nodes indicative of an abnormal short circuit of the upper, middle or lower switches.

**Fig. 2**

EP 4 708 655 A2

**Description**

BACKGROUND

The present invention is related to the field of switching DC-DC power converters.

SUMMARY

A non-isolated DC-DC converter is disclosed that includes a capability of detecting short circuits of its switching devices, so that faulty and potentially unsafe operating conditions can be avoided. The converter includes a transformer having a primary winding and a secondary winding, and switching circuitry that includes upper switches and middle switches of a primary-side inverter and lower switches of a secondary-side rectifier. The primary-side inverter has a primary-side test node between the upper and middle switches and is directly connected to the secondary-side rectifier to provide the converter output current as the sum of primary current and secondary current during ON intervals of a switching cycle. The converter further includes short-circuit detection circuitry that has (1) a resistive divider to establish normal values of the primary-side test node and a secondary-side test node in a non-short-circuit condition during pre-operation of the converter with all the switches in an OFF condition, and (2) sensing circuitry operative during the pre-operation of the converter to detect abnormal values of the primary-side and secondary-side test nodes indicative of an abnormal short circuit of the upper, middle or lower switches.

BRIEF DESCRIPTION OF THE DRAWINGS

The foregoing and other objects, features and advantages will be apparent from the following description of particular embodiments of the invention, as illustrated in the accompanying drawings in which like reference characters refer to the same parts throughout the different views.

Figure 1 is a schematic diagram of a non-isolated DC-DC converter;
Figure 2 is a schematic diagram of the converter of Figure 1 re-drawn to emphasize sets of switching transistors referred to as upper, lower and middle sets;
Figure 3 is a simplified flow diagram of a technique of testing a circuit like that of Figure 2 for short circuits of the switching transistors;
Figure 4 is a schematic diagram of a converter employing a first three-stage divider technique for testing for short circuits of the switching transistors;
Figure 5 is a schematic diagram of a variant of the converter of Figure 4 employing a blocking capacitor in the transformer primary along with an additional resistor to enable short-circuit testing;
Figure 6 is a schematic diagram of a converter employing a second three-stage divider technique for testing for short circuits of the switching transistors;
Figure 7 is a schematic diagram of a converter employing a two-stage divider technique for testing for short circuits of the switching transistors;
Figure 8 is a flow diagram of a testing process for the converter of Figure 7.

DETAILED DESCRIPTION

Overview; problem addressed

Power supply design and applications continue to develop towards high efficiency, miniaturization, high-frequency and intelligent. Switch-mode power supply (SMPS) with its small size and light weight, are widely used in computer, communication, power, instruments, home appliances, medical and other fields. As an efficient and reliable power output mode of SMPS, bridge DC/DC converter has been widely used. These include non-isolated full-bridge DCDC converters as distinct from isolated DC/DC converters, with advantages such as low cost, high efficiency and high power-density, providing a better solution for the application of high power field.

Non-isolated full-bridge DC/DC converters can be divided into two types according to the connection mode: traditional non-isolated control and optimized non-isolated control. Traditional non-isolated control is to directly connect the input ground to the output ground of the traditional isolated full-bridge DC/DC converter. In this condition, the converter's efficiency, power density and cost are similar to those of the isolated version.

Improved non-isolated control has a more optimized circuit topology. The improved non-isolated full-bridge converter has the advantages of simple circuit structure and low cost, effectively reducing the turn ratio of the transformer, while reducing the current stress of the rectifier switches, and can achieve higher power density. However, in the improved non-isolated full-bridge converter there is also increased risk that a faulty electrical connection may occur between the input and output, which is a serious fault condition that should be avoided.

Based on the above advantages, the improved non-isolated full-bridge DC/DC converter is applied to the field of switch-mode power supply. However, because there is no electrical isolation between input and output, there is a risk of input and output being directly connection. To protect the converter from a fault condition in which the input voltage passes through to the output voltage, a simple circuit and method for detecting the short circuit of the switching devices prior to converter startup is employed.

Embodiments

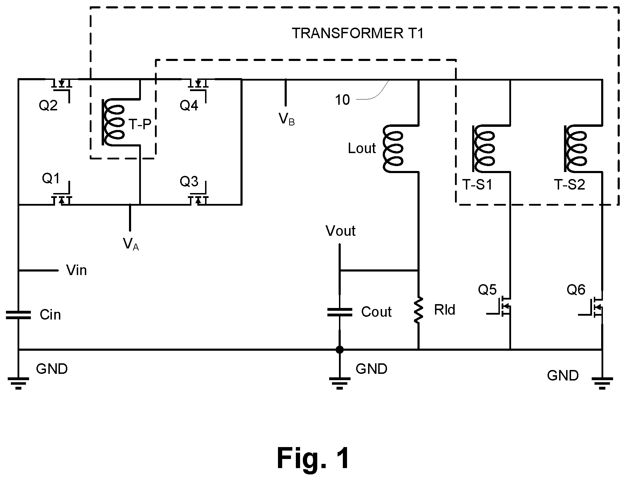

Figure 1 shows a non-isolated full bridge converter that includes a transformer T1, primary-side switches Q1-Q4 in full bridge configuration, secondary-side switches Q5-Q6, and other components including capacitors Cin, Cout, inductor Lout, and a representation of load as a load resistor Rld. The transformer T1 has a primary winding T-P and two secondary windings T-S1, T-S2. Both the primary-side circuitry and secondary-side circuitry are connected to a single shared ground GND. This common ground connection between the primary-side circuitry and the secondary-side circuitry establishes the "non-isolated" aspect of the arrangement. It will be understood that the transistors Q1-Q6 have their gates connected to respective switching control signals from separate control circuitry which, although not explicitly shown, will be understood by those skilled in the art to have structure and function to realize operation as described fully below.

More specifically:

1. A primary bridge comprises Q1, Q2, Q3, Q4, where the drains of Q1 and Q2 are connected together and connected to Vin source; the source of Q1 is connected to the drain of Q3 and connected to one end (voltage node $V_A$) of the primary winding T-P of transformer T1; the source of Q2 is connected to the drain of Q4 and connected to the other end of the primary winding T-P of transformer T1; and the sources of Q3 and Q4 are connected together (voltage node $V_B$);

2. The transformer T1 has primary winding T-P and secondary windings T-S1, T-S2, with the windings T-P, T-S1, and T-S2 being fully coupled to each other;

3. Output rectifier circuit includes Q5 and Q6, where Q5 is in series with T-S1, and Q6 is in series with Q6;

4. The source nodes of Q3 and Q4 are tied together and connected (via connection 10) to the output inductor Lout and the secondary center tap between T-S1 and T-S2;

5. The output filter includes the inductor Lout and capacitor Cout;

6. The number of turns of the primary winding T-P is Np, and the number of turns of the secondary windings T-S1 and T-S2 are equal and identified as Ns.

Overall operation is an ongoing series of switching cycles at regular intervals of duration T corresponding to a switching frequency, which may be in the range 10 - 100 kHz for example. Each cycle is divided into periods or intervals including two ON intervals (of duration D), referring to conduction of primary-side current, separated by two OFF intervals (of duration T-D), referring to the non-conduction of primary-side current. One feature of the non-isolated arrangement is that during each ON interval, the input current I-T-P flows to the output along with the secondary-side current, so that the total output current is equal to the sum of these currents. The secondary-side circuitry is not required to carry all of the output current. Advantages include the possibility of using a reduced transformer turns ratio for a given output voltage, lowering circuit costs and improving efficiency, and the possibility of using smaller secondary-side components due to reduced secondary-side current for a given load, also improving cost and efficiency.

However, as noted above, in the non-isolated arrangement there is a risk of a faulty electrical connection being created between the input and output, specifically in the case that a switching transistor (Q1 - Q6) develops a short-circuit. To protect the converter from such a faulty and potentially unsafe operating condition in which the input voltage passes through to the output voltage, a simple circuit and method for detecting the short circuit of the switching transistors are proposed.

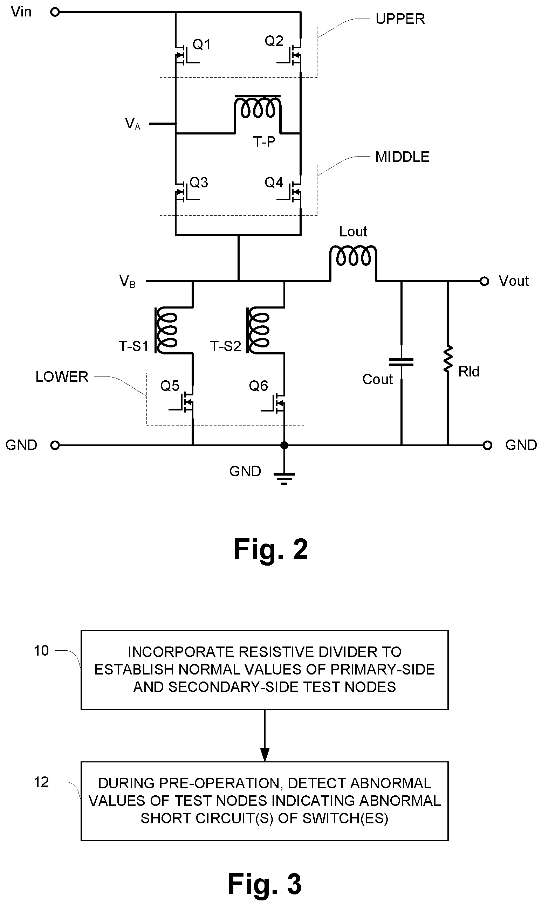

Figure 2 is the non-isolated converter of Figure 1 redrawn to emphasize certain aspects of its construction. The switching transistors are shown as divided into three types:

Q1 - Q2: Upper group, between Vin and $V_A$
Q3 - Q4: Middle group, between $V_A$ and $V_B$
Q5 - Q6: Lower group, between $V_B$ and GND

There are three distinct short-circuit failure conditions to be detected, namely a short-circuit in one of the upper switches Q1-Q2, in one of the middle switches Q3-Q4, and in one of the lower switches Q5-Q6. For the upper switches Q1-Q2, when either of these switches is short-circuited and the converter is not working (e.g., in standby mode), the node $V_A$ will effectively be directly connected to Vin (via primary winding T-P in the case of Q2 short-circuit), so the voltage of node

$V_A$ will be close to the input voltage Vin. In the case of a short circuit in one of the middle switches Q3-Q4, the node $V_A$ will be connected to Vout through the output inductor Lout (via primary winding T-P in the case of Q4 short-circuit), so the voltage of node $V_A$ will be close to the output voltage Vout. For a short circuit of one of the lower switches Q5-Q6, the node $V_B$ will be short-circuited to ground through the a respective secondary winding T-S1 or T-S2, resulting in the voltage of $V_B$ being close to 0. Thus, a testing technique is proposed based on checking for any of these faulty short-circuit voltages for $V_A$ or $V_B$, as distinguished from their normal voltage values in the absence of a short-circuit condition.

Figure 3 is a simplified flow diagram of the testing technique in one embodiment. At 10, the technique includes incorporating a resistive divider into the converter to establish normal values of a primary-side test node (e.g., node $V_A$) and a secondary-side test node (e.g., node $V_B$), which are voltage values in a non-short-circuit condition during pre-operation of the converter with all the switches in an OFF condition. At 12, sensing circuitry is operative during the pre-operation of the converter to detect abnormal values of the primary-side and secondary-side test nodes indicative of an abnormal short circuit of one or more of the upper, middle and lower switches. In one approach, such abnormal values are detected by comparing the actual test node voltages to respective short-circuit voltages that would be expected in a short-circuit condition, e.g., VA = Vin or VB = 0.

Several alternative approaches are described below. These approaches all have a self-referenced aspect to them, i.e., voltages are compared to normal operating values for the given converter. For different non-isolated full-bridge DC/DC power supplies, the input voltage, output voltage and transformer turn ratio generally vary. To effectively distinguish the state of the upper, middle or lower switches between short-circuit condition and the normal condition, a circuit is added to adjust the node voltage to distinguish between normal and short-circuit condition of the switches before the converter is started.

## 1. Three-stage voltage division method

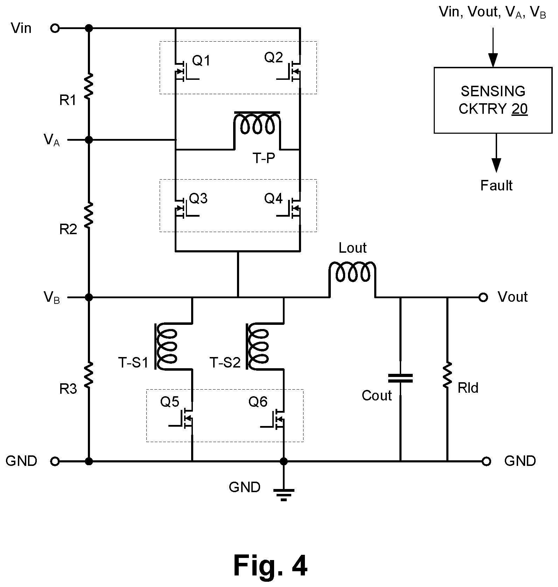

Figure 4 illustrates an example of a first testing approach referred to as a "three-stage voltage division method." Resistors R1, R2 and R3 are added to the converter circuit in a voltage-divider arrangement as shown. Testing is based on detection of the value of $V_A$ to distinguish between normal and short circuit in the upper and middle switches, and detection of the value of $V_B$ to distinguish between normal and short circuit in the lower switches. Testing is performed by sensing circuitry (CKTRY) 20 when the converter is in standby state (before start up). In one embodiment, the sensing circuitry 20 is incorporated into control circuitry (not shown) that manages overall operation of the converter.

When the switch transistor Q1 or Q2 is short-circuited, the $V_A$ voltage is equal to Vin. When the switch transistor Q3 or Q4 is short-circuited, the $V_A$ voltage is equal to Vout. Resistors R1, R2 and R3 are used to establish normal values for the voltages $V_A$ and $V_B$ (i.e., voltage values in the absence of short circuits). Generally, the resistance values of R1 - R3 are much smaller than the static drain-to-source off resistance Rdsoff of the switches Q1 - Q6. Also, so that no higher voltage is directly divided through Vin to Vout in the case of non-operation state, the resistance values of R1 and R2 should be much greater than R3. Also, for R3 to provide measurable effect, its resistance must be much smaller than the ground resistance Rld. Specific ranges of these resistance values are given below.

In the absence of short circuit when the converter is in standby mode, the normal voltage of node $V_A$ (VAnom) is shown below.

$$VAnom = (Vin - Vout) \times \frac{R2}{R1 + R2} + Vout$$

The following conditions must be met to distinguish upper- or middle-switch short circuits from normal, non-short-circuit conditions.

$$Vin > VAnom > Vout$$

$$\text{i.e., } 1 > \frac{R2}{R1+R2} > 0, \ Rdsoff \gg R1 \gg R3, \ Rdsoff \gg R2 \gg R3$$

When the converter is in standby mode and a lower switch is short-circuited, the $V_B$ voltage is close to 0. If there is a large pre-bias voltage in Vout (i.e., Vout is well above 0 volts), this means that lower switches Q5-Q6 are not short-circuited. If Vout has no large bias voltage, the voltage corresponding to $V_B$ under normal (non-short-circuited) conditions is shown below:

$$VBnom = Vin \times \frac{Rld//R3}{Rld//R3 + R1 + R2}$$

The following conditions must be met to distinguish a lower switch short circuit from normal.

$$VBnom > 0$$

Rld is the impedance from Vout to ground when converter is in standby mode. When Rld is at 10 kohm level and Rdsoff is at 10 Mohm level or above, the impedance of R1 and R2 can be set at approximately the 100 kohm level, and the impedance of R3 should be at 1 kohm level. The ratio of R1 and R2 should be selected to distinguish $V_A$ from Vin and Vout, so that the short circuit in upper or middle switches can be detected. One good ratio of R1 to R2 is 1:1. As long as the voltage after the partial voltage of $V_B$ can meet the sampling requirements and distinguish the zero voltage from it, distinguishing normal state from the short circuit can be realized.

Assuming the above normal values for $V_A$ and $V_B$, the following conditions at startup indicate short-circuit conditions as follows:

    1. $V_A$ = Vin: Q1 or Q2 short-circuited
    2. $V_A$ = Vout: Q3 or Q4 short-circuited
    3. $V_B$ = 0: Q5 or Q6 short-circuited

Although the above suggests three separate tests for respective fault-indicating values, in another embodiment each voltage $V_A$, $V_B$ can be compared with its respective normal/nominal value VAnom, VBnom, and if both voltages have their normal/nominal pre-operation value, then no short-circuit condition is detected and normal operation of the converter is enabled.

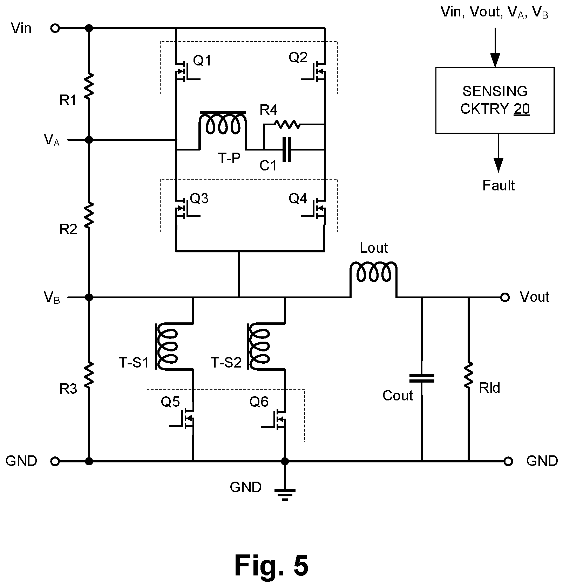

Figure 5 shows a variant of the circuit of Figure 4 which employs a capacitor C1 to prevent unbalancing of the transformer T1 during regular switching operation of the converter. The presence of this capacitor removes the DC path between the node $V_A$ and the switches Q2 and Q4, and thus complicates the detection of short circuits in these devices. In order to detect the anomalies in Q2 and Q4 through $V_A$, a resistor R4 is added as shown in Figure 5. The resistance of R4 should be much smaller than that of R1 and R2 (e.g., approximately 1 kohm when R1 and R2 are 10 kohms). By adding R4, the testing technique as described above for the circuit of Figure 4 can be used.

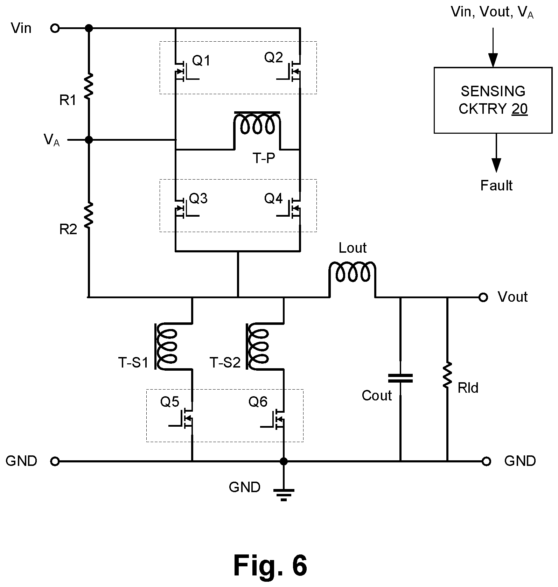

Figure 6 shows a three-stage voltage division approach similar to that of Figure 4 as described above, except without requiring the resistor R3. This is possible because of the presence of the ground impedance Rld in the general circuit design. The technique is modified to rely on the normal voltages established by Rld in combination with R1 and R2.

In the circuit of Figure 6, when the switch transistor Q1 or Q2 is short-circuited, the $V_A$ voltage is equal to Vin. When the switch transistor Q3 or Q4 is short-circuited, the $V_A$ voltage is equal to Vout. Resistors R1 and R2 are used to establish normal values for the voltages $V_A$ and $V_B$ (i.e., voltage values in the absence of short circuits). Generally, the resistance values of R1 and R2 are much smaller than the static drain-to-source off resistance Rdsoff of the switches Q1 - Q6. Also, so that no higher voltage is directly divided through Vin to Vout in the case of non-operation state, the resistance values of R1 and R2 should be much greater than Rld. Specific ranges of these resistance values are given below.

In the absence of short circuits, with the converter in standby mode, the $V_A$ voltage is shown below.

$$VAnom = (Vin - Vout) \times \frac{R2}{R1 + R2} + Vout$$

The following conditions must be met to distinguish the upper or middle switch short circuit from normal.

$$Vin > VAnom > Vout$$

$$\text{i.e., } 1 > \frac{R2}{R1+R2} > 0, \ Rdsoff \gg R1 \gg Rld, \ Rdsoff \gg R2 \gg Rld$$

When the converter is in standby mode, and a lower switch Q5 or Q6 is short-circuited, the Vout voltage is close to 0. If there is a large pre-bias voltage in Vout, then neither Q5 nor Q6 is short-circuited. If the Vout has no high bias voltage, then in normal operation the normal output voltage Voutnom is as shown below:

$$Voutnom = Vin \times \frac{Rld}{Rld + R1 + R2}$$

The following conditions must be met to distinguish the lower switch short circuit from normal:

$$Voutnom > 0$$

When Rld is at 10 kohm level and Rdsoff is at 10 Mohm level or higher, R1 and R2 are preferably at about the 100 kohm level. The ratio of R1 and R2 should be selected to distinguish $V_A$ from Vin and Vout, so that a short circuit in the upper or middle switches can be detected. A good ratio of R1 to R2 is 1:1. The voltage after the partial voltage of Vout can be distinguished from the short circuit as long as it can meet the sampling requirements and distinguish the 0 voltage from the voltage.

2. Two-stage voltage division method:

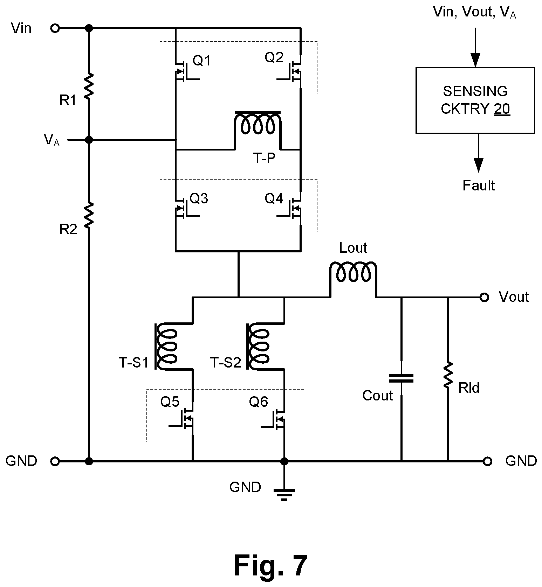

Figure 7 illustrates an example of a second testing approach referred to as a "two-stage voltage division method." In order to prevent Vout from having small voltages directly to Vout through Vin before startup, the resistor R2 is directly connected to GND in contrast to the three-stage voltage division method. R1 and R2 are used to detect $V_A$ to distinguish between normal and short circuits in the upper and middle switches, and Vout is used to distinguish between normal and short circuits in the lower switches.

During pre-operation of the circuit of Figure 7, when the switch transistor Q1 or Q2 is short-circuited, the $V_A$ voltage is equal to Vin. When the switch transistor Q3 or Q4 is short-circuited, the $V_A$ voltage is equal to Vout. Resistors R1 and R2 are used to establish normal values for the voltages $V_A$ and $V_B$ (i.e., voltage values in the absence of short circuits). Generally, the resistance values of R1 and R2 are much smaller than the static drain-to-source off resistance Rdsoff of the switches Q1 - Q6.

When the switches are normal and the converter is in standby mode, the $V_A$ voltage is as shown below:

$$VAnom = Vin \times \frac{R2}{R1 + R2}$$

The following conditions must be met to distinguish the upper or middle switch short circuit from normal:

$$Vin > VAnom > Vout$$

$$\text{i.e., } 1 > \frac{R2}{R1+R2} > \frac{Vout}{Vin}, \; Rdsoff \gg R1 \,, \; Rdsoff \gg R2$$

When a lower switch Q5 or Q6 is short-circuited and the converter is in standby mode, the Vout voltage is close to 0. In the case of static standby operation, if there is a large pre-bias voltage in Vout, then neither of the switches Q5 nor Q6 is short-circuited. But if Vout has no high bias voltage, then when the lower switches Q5 and Q6 are normal, the corresponding voltage of Vout is 0 (due to the lack of R3), which is the same as a short-circuit condition. Thus, to differentiate the normal and short-circuit conditions, a pulsing operation is used to drive Vout to some measurable, non-zero test voltage through the full-bridge partial circuit, then Vout is sensed to determine whether it has reached such a non-zero test voltage (indicating absence of short circuits) or remains at 0 (indicating short-circuit condition).

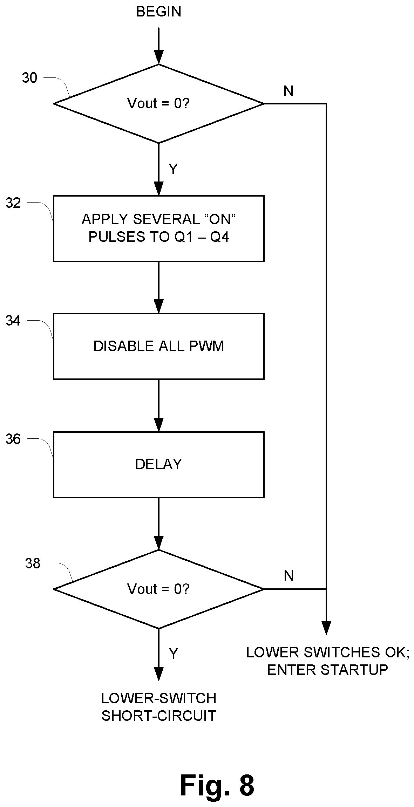

Figure 8 illustrates the above technique, which may be performed by the converter controller including the sensing circuitry 20. At 30 it is determined whether Vout is equal to 0; if not, then the lower switches are normal (non-shorted) and thus normal converter startup can be performed. If Vout is zero, then at 32 several ON pulses are supplied to the switches Q1-Q4 to drive Vout to the small test value as described above. This is followed by disabling the PWM pulsing at 34 and observing a small delay at 36. Then at 38, Vout is compared to zero again. If it is non-zero, then the lower switches Q5, Q6 are normal (non-shorted) and thus normal converter startup can be performed. If Vout is equal to zero, it indicates that one (or both) of the lower switches is short-circuited, and this indication can be used to signal a fault condition and refrain from the normal startup of the converter.

Referring again to the techniques of Figures 6 and 7, it will be appreciated that these may also be used when the converter includes a blocking capacitor C1, simply by also incorporating the resistor R4 as shown in Figure 5.

While various embodiments of the invention have been particularly shown and described, it will be understood by those skilled in the art that various changes in form and details may be made therein without departing from the scope of the invention as defined by the appended claims.

**Claims**

1. A non-isolated DC-DC converter, comprising:

   a transformer having a primary winding and a secondary winding;
   switching circuitry including upper switches and middle switches of a primary-side inverter and lower switches of a secondary-side rectifier, the primary-side inverter having a primary-side test node between the upper and middle switches and being directly connected to the secondary-side rectifier to provide the converter output current as the sum of primary current and secondary current during ON intervals of a switching cycle; and
   short-circuit detection circuitry including (1) a resistive divider to establish normal values of the primary-side test node and a secondary-side test node in a non-short-circuit condition during pre-operation of the converter with all the switches in an OFF condition, and (2) sensing circuitry operative during the pre-operation of the converter to detect abnormal values of the primary-side and secondary-side test nodes indicative of an abnormal short circuit of the upper, middle or lower switches.

2. The non-isolated DC-DC converter of claim 1, wherein the resistive divider is a three-stage divider having a set of series-connected resistors each in parallel with respective ones of the upper, middle and lower switches, and wherein the primary-side test node is a first node between first and second ones of the resistors having a first normal voltage between an input voltage Vin and an output voltage Vout of the converter, and the secondary-side test node is a second node between second and third ones of the resistors having a second normal voltage between the input voltage and output voltage of the converter, and wherein the abnormal values of the primary-side and secondary-side test nodes are (1) Vin for the primary-side test node, indicating a short-circuit of one of the upper switches, (2) Vout for the primary-side test node, indicating a short-circuit of one of the middle switches, (3) 0 for the secondary-side test node, indicating a short-circuit of one of the lower switches.

3. The non-isolated DC-DC converter of claim 2, including a primary-side blocking capacitor to prevent unbalancing of the transformer in operation, the blocking capacitor being in series between the primary-side test node and one of the upper switches, and wherein the short-circuit detection circuitry includes an additional resistor in parallel with the blocking capacitor to provide a current path enabling the primary-side test node to take on the Vin value for a short circuit of the one upper switch.

4. The non-isolated DC-DC converter of claim 1, wherein the resistive divider is a three-stage divider having a set of series-connected resistors each in parallel with respective ones of the upper and middle switches, and wherein the primary-side test node is a first node between first and second ones of the resistors having a first normal voltage between an input voltage Vin and an output voltage Vout of the converter, and the secondary-side test node being an output node of the converter, and wherein the abnormal values of the primary-side and secondary-side test nodes are (1) Vin for the primary-side test node, indicating a short-circuit of one of the upper switches, (2) Vout for the primary-side test node, indicating a short-circuit of one of the middle switches, (3) 0 for the output node of the converter, indicating a short-circuit of one of the lower switches.

5. The non-isolated DC-DC converter of claim 1, wherein the resistive divider is a two-stage divider having a set of series-connected resistors, a first one of the resistors being in parallel with the upper switches, and a second one of the resistors being connected between the first resistor and ground, and wherein the primary-side test node is a first node between the first and second resistors having a first normal voltage between an input voltage Vin and an output voltage Vout of the converter, and wherein the secondary-side test node an output node of converter, and wherein the abnormal values of the primary-side and secondary-side test nodes are (1) Vin for the primary-side test node, indicating a short-circuit of one of the upper switches, (2) Vout for the primary-side test node, indicating a short-circuit of one of the middle switches, (3) 0 for the output node of the converter, indicating a short-circuit of one of the lower switches, the 0 value being detected after a pulsing operation performed by the sensing circuitry effective to drive Vout to a measurable non-zero value in the absence of a short circuit of the lower switches.

6. A method of testing a non-isolated DC-DC converter for the presence of a short circuit in any of upper, middle and lower switches thereof, comprising:

   incorporating a resistive divider to establish normal values of a primary-side test node and a secondary-side test node in a non-short-circuit condition during pre-operation of the converter with all the switches in an OFF condition; and

operating sensing circuitry during the pre-operation of the converter to detect abnormal values of the primary-side and secondary-side test nodes indicative of an abnormal short circuit of the upper, middle or lower switches.

7. The method of claim 6, wherein the resistive divider is a three-stage divider having a set of series-connected resistors each in parallel with respective ones of the upper, middle and lower switches, and wherein the primary-side test node is a first node between first and second ones of the resistors having a first normal voltage between an input voltage Vin and an output voltage Vout of the converter, and the secondary-side test node is a second node between second and third ones of the resistors having a second normal voltage between the input voltage and output voltage of the converter, and wherein detecting the abnormal values of the primary-side and secondary-side test nodes includes (1) detecting Vin for the primary-side test node, indicating a short-circuit of one of the upper switches, (2) detecting Vout for the primary-side test node, indicating a short-circuit of one of the middle switches, (3) detecting 0 for the secondary-side test node, indicating a short-circuit of one of the lower switches.

8. The method of claim 7, wherein the converter includes a primary-side blocking capacitor to prevent unbalancing of the transformer in operation, the blocking capacitor being in series between the primary-side test node and one of the upper switches, and further includes an additional resistor in parallel with the blocking capacitor to provide a current path enabling the primary-side test node to take on the Vin value for a short circuit of the one upper switch.

9. The method of claim 6, wherein the resistive divider is a three-stage divider having a set of series-connected resistors each in parallel with respective ones of the upper and middle switches, and wherein the primary-side test node is a first node between first and second ones of the resistors having a first normal voltage between an input voltage Vin and an output voltage Vout of the converter, and the secondary-side test node being an output node of the converter, and wherein detecting the abnormal values of the primary-side and secondary-side test nodes includes (1) detecting Vin for the primary-side test node, indicating a short-circuit of one of the upper switches, (2) detecting Vout for the primary-side test node, indicating a short-circuit of one of the middle switches, (3) detecting 0 for the output node of the converter, indicating a short-circuit of one of the lower switches.

10. The method of claim 6, wherein the resistive divider is a two-stage divider having a set of series-connected resistors, a first one of the resistors being in parallel with the upper switches, and a second one of the resistors being connected between the first resistor and ground, and wherein the primary-side test node is a first node between the first and second resistors having a first normal voltage between an input voltage Vin and an output voltage Vout of the converter, and wherein the secondary-side test node an output node of converter, and wherein detecting the abnormal values of the primary-side and secondary-side test nodes includes (1) detecting Vin for the primary-side test node, indicating a short-circuit of one of the upper switches, (2) detecting Vout for the primary-side test node, indicating a short-circuit of one of the middle switches, (3) detecting 0 for the output node of the converter, indicating a short-circuit of one of the lower switches, the 0 value being detected after a pulsing operation performed by the sensing circuitry effective to drive Vout to a measurable non-zero value in the absence of a short circuit of the lower switches.

11. The method of claim 10, wherein the pulsing operation is performed after first detecting 0 for the output node and includes:

applying a plurality of ON pulses to the upper and middle switches in a manner effective to drive Vout to the measurable non-zero value in the absence of a short circuit of the lower switches;
next disabling all pulse-width modulation of the switches, and then delaying a predetermined time;
next detecting whether Vout remains at 0, indicating a short circuit of one of the lower switches.

**Fig. 1**

**Fig. 2**

10 — INCORPORATE RESISTIVE DIVIDER TO ESTABLISH NORMAL VALUES OF PRIMARY-SIDE AND SECONDARY-SIDE TEST NODES

12 — DURING PRE-OPERATION, DETECT ABNORMAL VALUES OF TEST NODES INDICATING ABNORMAL SHORT CIRCUIT(S) OF SWITCH(ES)

**Fig. 3**

# Fig. 4

**Fig. 5**

Fig. 6

**Fig. 7**

BEGIN

30 — Vout = 0? —N→

Y

32 — APPLY SEVERAL "ON"
PULSES TO Q1 – Q4

34 — DISABLE ALL PWM

36 — DELAY

38 — Vout = 0? —N→

Y

LOWER-SWITCH
SHORT-CIRCUIT

LOWER SWITCHES OK;
ENTER STARTUP

# Fig. 8